# EUROPÄISCHE PATENTSCHRIFT

(11) **EP 1 158 598 B1**
(45) Veröffentlichungstag und Bekanntmachung des Hinweises auf die Patenterteilung: **17.11.2004**
(21) Anmeldenummer: 01109630.2
(22) Anmeldetag: 19.04.2001
(51) Int. Cl.: H01P 5/10, H03D 7/14

(54) **Anordnung zum Transformieren von Übertragungsleitungsstrukturen und Mischer**
Device for transformation of transmission line structures and mixer
Dispositif pour transformer des structures de lignes de transmission et mélangeur

(30) Priorität: 26.05.2000 DE 10026227
(43) Veröffentlichungstag der Anmeldung: 28.11.2001
(73) Patentinhaber: Marconi Communications GmbH, 71522 Backnang (DE)
(72) Erfinder: Gill, Hardial Singh, 71522 Backnang (DE); Krupa, Richard, 71540 Murrhardt (DE)
(74) Vertreter: Gleiss & Grosse

(56) Entgegenhaltungen:
- EP-A- 1 132 995
- US-A- 4 380 831
- US-A- 5 428 838
- US-A- 5 819 169
- SCHELLENBERG J ET AL: "LOW-LOSS, PLANAR MONOLITHIC BALUNS FOR K/KA-BAND APPLICATIONS" 1999 IEEE MTT-S INTERNATIONAL MICROWAVE SYMPOSIUM DIGEST. (IMS). ANAHEIM, CA, JUNE 13 - 19, 1999, IEEE MTT-S INTERNATIONAL MICROWAVE SYMPOSIUM, NEW YORK, NY: IEEE, US, Bd. 4, 13. Juni 1999 (1999-06-13), Seiten 1733-1736, XP000890692 ISBN: 0-7803-5136-3

## Beschreibung

Die Erfindung betrifft einen Mischer mit Anordnungen zum Transformieren einer unausgeglichenen Übertragungsleitungsstruktur in eine ausgeglichene Übertragungsleitungsstruktur.

Es ist bekannt, Sternmischer mit zwei ausgeglichenen Ausgängen mittels unterschiedlicher Techniken zu gestalten. In Frage kommende Techniken verwenden beispielsweise Koaxialleitungen, Streifenleitungen ("striplines"), Wellenleiter, Bifilarwicklungen auf Ferritkernen oder magnetisch gekoppelte Transformatorwicklungen. Zudem ist aus der US 5,428,838 ein Diodenmixer in planarmonolithischer Bauweise bekannt. Ein herkömmlicher Sternrnischer weist unerwünschte Konversionsverluste von etwa 10 dB auf. Es verbleibt daher der Wunsch nach einem Mischer mit geringeren Konversionsverlusten. Des Weiteren ist die Veröffentlichung von Schellenberg et al. "Low-loss, planar molotlithic baluns for K/Ka-band applications" 1999 IEEE MTT-S International Microwave Symposium Digest (IMS) Anaheim, Ca, June 13-19, 1999, IEEE MTT-S Intemational Microwave Symposium, New York, NY; IEEE, US, Bd. 4, 13. Juni 1999 (1999-06-13), Seiten 1733-1736, XP000890692 ISBN: 0-7803-5136-3 zu nennen, die einen Balun (balanced-to-unbalanced transformer) mit geringen Verlusten aufzeigt. Zudem ist aus der EP 1 132 995 A1, welche Stand der Technik unter Artikel 54(3) EPÜ darstellt, ein sehr platzsparendes und mit geringem Aufwand herstellbares breitbandiges Symmetrierglied bekannt.

Im niedrigen Mikrowellenfrequenzbereich werden herkömmlich nur Koaxialleitungstechniken verwendet. Die Beschränkung auf diese Techniken limitiert die Einsatzbereiche der Anordnungen des Standes der Technik, insbesondere im Hinblick auf die geometrischen Strukturen, die Bandbreite und die Leistungsverluste.

Die Erfindung baut gemäß Anspruch 1 auf den Stand der Technik dadurch auf, dass zwei Anordnungen (Baluns) vorgesehen sind und die ausgeglichenen Ausgänge der jeweiligen Anordnungen paarweise miteinander verbunden sind, wobei an den Verbindungspunkten Mischerdioden angeordnet sind. Die Signale eines Lokaloszillators und einer Radiofrequenzquelle werden an den unausgeglichenen Eingangsports zugeführt und gelangen an den Kreuzungspunkten der beiden Dual-Baluns zu vier Dioden, vorzugsweise vier P-HEMT-Dioden. Des Weiteren ist eine Ringstruktur zum Verbinden der Mischerdioden vorgesehen. Dies hat bezüglich der Integration auf einem einzelnen Chip Vorteile. Es ist möglich, die Verbindungsleitung in dem Ring sehr kurz zu halten, so dass der Einfluss parasitärer Induktanzen der Verbindungsleitungen minimiert wird. Schließlich sind an der Ringstruktur vier offene Abstimmleitungen angeschlossen. Durch die Länge dieser Abstimmleitungen lassen sich unerwünschte Frequenzbänder kurzschließen.

Bevorzugt ist der Mischer zur Isolierung eines Lokaloszillators von einer Radiofrequenzquelle symmetrisch. Je genauer eine Symmetrie erreicht wird, desto besser ist die zur Verfügung gestellte Isolierung des Lokaloszillators gegen die Radiofrequenz.

In diesem Zusammenhang ist es besonders vorteilhaft, wenn die offenen Abstimmleitungen eine Länge haben, welche einem Viertel der Wellenlänge der zweiten Harmonischen des Lokaloszillators entspricht. Folglich werden die zweiten Harmonischen der Lokaloszillatorfrequenz kurzgeschlossen, was zu einer Verringerung der Konversionsverluste führt. Ein solches Kurzschließen der zweiten Harmonischen ist im Rahmen von Sternmischern nicht üblich. Folglich werden die Konversionsverluste, die bei herkömmlichen Sternmischern bei etwa 10 dB liegen, vorteilhaft auf weniger als 10 dB in einem Bereich zwischen 15 GHz bis 45 GHz gesenkt.

Es ist bevorzugt, wenn ein Zwischenfrequenz-Choke ("IF-Choke") mit einer λ/4-Länge vorgesehen ist, welcher über eine Reihenschaltung eines Kondensators und eines Ohmschen Widerstandes geerdet ist. Mit einem solchen Abschluss erreicht man die Unterdrückung störender Resonanzen in der Schaltung. Der Zwischenfrequenzport ist so gestaltet, dass er für die Dioden ein Bias zur Verfügung stellt, so dass die Isolierung des Lokaloszillators gegen die Radiofrequenz und die Lokaloszillatorunterdrückung verbessert werden.

Im Hinblick auf den Abschluss des Zwischenfrequenzports hat es sich als besonders nützlich erwiesen, wenn der Kondensator eine Kapazität in der Größenordnung Pikofarad aufweist und wenn der Ohmsche Widerstand einige Ohm beträgt.

Auf diese Weise erhält man eine besonders gute Unterdrückung von unerwünschten Resonanzen.

Die für den Mischer verwendeten Anordnungen zeichnen sich dadurch aus, dass eine erste Struktur vorgesehen ist, dass eine zweite Struktur vorgesehen ist, dass die erste Struktur drei gekoppelte parallele Leitungen aufweist, wobei jeweils ein erstes Ende einer ersten und einer dritten Leitung an einem unausgeglichenen Eingangsport geerdet sind und wobei die jeweils anderen Enden der ersten und der dritten Leitung zu zwei ausgeglichenen Ausgängen führen, dass die zweite Struktur drei gekoppelte parallele Leitungen aufweist, wobei jeweils ein erstes Ende einer ersten und einer dritten Leitung geerdet sind und wobei die jeweils anderen Enden der ersten und der dritten Leitung zu zwei ausgeglichenen Ausgängen führen, und dass eine zweite Leitung der ersten und der zweiten Struktur die Strukturen miteinander verbindet. Eine derartige Anordnung hat die Funktion eines Balun ("balanced-to-unbalanced transformer"), das heißt eine ausgeglichene ("balanced") Struktur wird mit einer unausgeglichenen ("unbalanced") Struktur gekoppelt. Die Kopplung des unausgeglichenen Eingangsports zu jedem der ausgeglichenen Ausgangsports betragt -3 dB. Der vorliegende Dual-Balun ist daher ein effizienter Leistungsteiler, und er stellt einen Übergang von einem unausgeglichenen Eingang zu zwei ausgeglichenen Ausgängen zur Verfügung. Die Anordnung hat eine wesentlich größere Bandbreite (mehrere Oktaven) als herkömmlich verwendete Leistungsteiler, und sie weist geringe Verluste auf. Ebenso ist es möglich, dass die geraden Harmonischen der Signale gelöscht werden. Die ausgeglichenen Ausgangsports sind voneinander isoliert, wobei die Ausgangssignale gleiche Amplituden und gleiche Phasen aufweisen.

Vorzugsweise ist die Anordnung als planare Struktur ausgebildet. Eine solche Balun-Geometrie, welche insbesondere keine diskreten Elemente aufweist, ist besonders vielfältig einsetzbar.

Es ist bevorzugt, dass Kurzschlüsse über plattierte Durchgangslöcher realisiert sind. Auf diese Weise werden die Kurzschlüsse in zuverlässiger Weise zur Verfügung gestellt.

Vorzugsweise ist die Anordnung in MicrostripLeitungstechnik ausgebildet. Dies ist wiederum im Sinne möglichst vielfältiger Einsatzmöglichkeiten.

Besonders bevorzugt ist es, wenn die Anordnung als monolithische integrierte Mikrowellenschaltung ("monolithic microwave integrated circuit" (MMIC)) ausgebildet ist. Dies ist insbesondere im Sinne einer Größenreduzierung, zu der es aufgrund der Verwendung monolithischer integrierter Mikrowellenschaltungen kommt.

Es kann nützlich sein, dass die Anordnung als gedruckte Schaltung in einer Einzelschicht ausgebildet ist. Der Balun ist daher rationell herstellbar, und er lässt sich bei zahlreichen Anwendungen einsetzen.

Vorzugsweise sind die ausgeglichenen Ausgänge symmetrisch bezüglich Erde. Somit liegt eine wohldefinierte Ausgangscharakteristik vor, weshalb sich der Balun besonders vorteilhaft in Mischern und Modulatoren einsetzen lässt.

Bevorzugt ist die Microstrip-Leitung so ausgebildet, dass der Gesamtstrom der unteren Grundfläche entgegengesetzt gleich dem Gesamtstrom des oberen Leiters ist. Der Grad der Unausgeglichenheit des Systems hängt von dem Grad der Übertragung des Stroms der unteren Grundfläche zu dem Strom des ausgeglichenen Leiters ab. Auf diese Weise wird eine Kopplung zu jedem ausgeglichenen Ausgangsport von -3 dB zur Verfügung gestellt.

Vorzugsweise ist die Grundfläche isoliert. Somit wird der gesamte Strom der Grundfläche mit geeigneter Phase zu einem der ausgeglichenen Leiter geführt.

Es kann vorteilhaft sein, wenn die Anordnung eine "Wiggly"-Struktur aufweist. Damit ist nochmals eine Größenreduzierung des Balun möglich.

Bevorzugt sind die gekoppelten Leitungsstrukturen λ/4-Leitungen. Hierdurch wird ein vorteilhaftes Übertragungsverhalten sichergestellt. Der Erfindung liegt die überraschende Erkenntnis zugrunde, dass die Kombination eines Dual-Baluns mit einer neuen Sternmischerkonfiguration zu zahlreichen Vorteilen führt. Der Dual-Balun hat eine wesentlich größere Bandbreite als herkömmlich verwendete Leistungsteiler und geringe Verluste. Ebenso ist er in der Lage, die geraden Harmonischen der Signale auszulöschen. Die Ausgangsports werden voneinander isoliert, und die Ausgangssignale der ausgeglichenen Ports sind bezüglich Amplitude und Phase gleich. Bei einem Sternmischer, welcher diese Anordnung verwendet, werden vorzugsweise die zweiten Harmonischen des Lokaloszillators und der Radiofrequenzsignale in der Mitte der Sternanordnung kurzgeschlossen, um die Konversionsverluste zu verringern. Im Falle der Frequenzherabsetzung wird die Zwischenfrequenz dem Diodenstern entnommen, während die Lokaloszillatorfrequenz und die Radiofrequenz bei den asymmetrischen Dual-Balunports eingegeben werden.

Die Erfindung wird nachfolgend anhand bevorzugter Ausführungsformen mit Bezug auf die begleitenden Zeichnungen beispielhaft beschrieben.

Es zeigen:
- Figur 1: eine schematische Darstellung einer zum erfindungsgemäßen Mischer gehörenden Anordnung und
- Figur 2: eine schematische Darstellung eines erfindungsgemäßen Mischers.

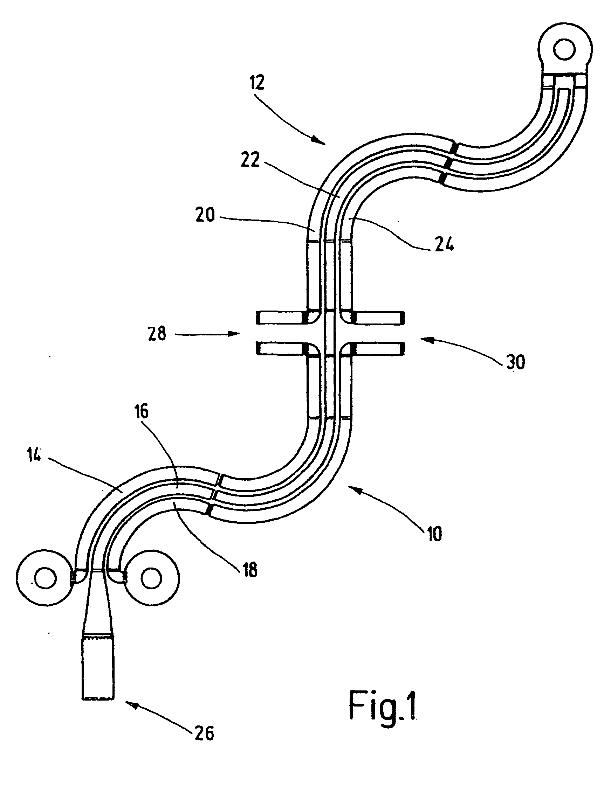

Figur 1 zeigt eine Anordnung in schematischer Darstellung. Die Anordnung hat eine erste Struktur 10 und eine zweite Struktur 12. Sowohl die erste Struktur 10 als auch die zweite Struktur 12 weisen jeweils drei gekoppelte parallele Leitungen 14, 16, 18 beziehungsweise 20, 22, 24 auf. Jeder gekoppelte Leitungsabschnitt hat eine Länge von λ/4. Die erste Struktur 10 ist so aufgebaut, dass jeweils ein erstes Ende einer ersten Leitung 14 und ein erstes Ende einer dritten Leitung 18 an einem unausgeglichenen Eingangsport 26 geerdet sind. Die jeweils anderen Enden der ersten und der dritten Leitung 14, 18 führen jeweils zu zwei ausgeglichenen Ausgangsports 28, 30. Bei der zweiten Struktur 12 sind ebenfalls ein erstes Ende einer ersten Leitung 20 and einer dritten Leitung 24 geerdet, und die jeweils anderen Enden führen zu zwei ausgeglichenen Ausgangsports 28, 30. Eine zweite Leitung 16 der ersten Struktur 10 ist mit einer zweiten Leitung 22 der zweiten Struktur 12 verbunden, so dass diese Leitung 16, 22 die erste Struktur 10 mit der zweiten Struktur 12 verbindet. Die Kurzschlüsse sind mittels plattierter Durchgangslöcher realisiert. Die Größe des Balun beträgt etwa eine halbe Wellenlänge. Zur Reduzierung der Balungröße wird eine "Wiggly"-Struktur verwendet. Der Balun ist aus vollständig planaren gekoppelten Strukturen gebildet, and er kann als gedruckte Einzelschichtschaltung ausgelegt sein. Die Struktur weist keine diskreten Elemente auf. Die exakte Dimensionierung kann mittels eines 3D-Feldsimulators an den Übergängen und "Libra" bestimmt werden.

Der Balun gemäß Figur 1 kann für die Gestaltung von Sternmischern and Modulatoren eingesetzt werden, wobei die Potentiale der Ausgangsports 28, 30 den jeweiligen Mischerdioden zugeführt werden.

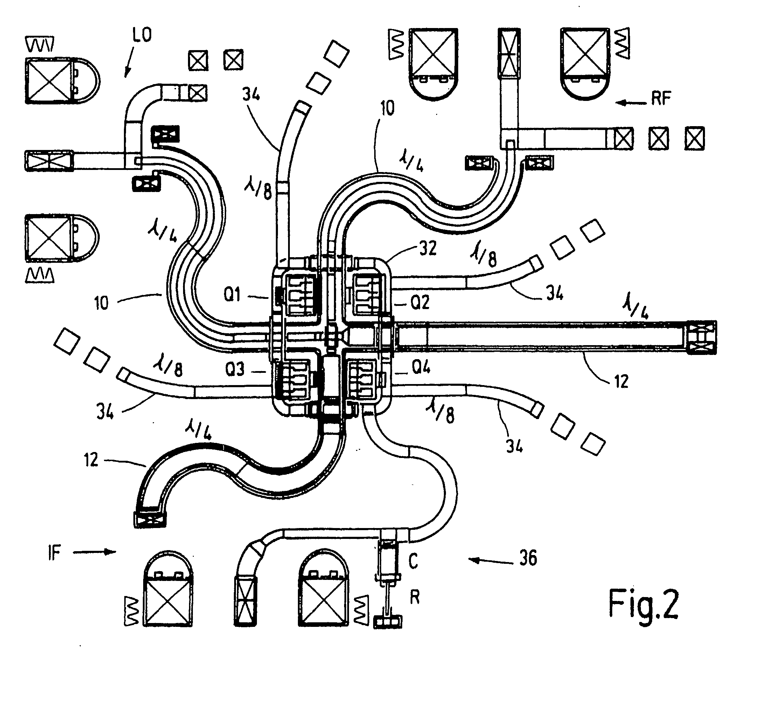

Figur 2 zeigt eine Ausführungsform eines erfindungsgemäßen Mischers. Dieser weist zwei Baluns auf, welche an den gemeinsamen ausgeglichenen Ports miteinander verbunden sind. An den Eingängen der unausgeglichenen Strukturen 10 werden die Lokaloszillatorfrequenz LO beziehungsweise die Radiofrequenz RF eingespeist. An den Kreuzungspunkten der beiden Baluns sind vier P-HEMT-Dioden Q1, Q2, Q3, Q4 angeordnet. Der gemeinsame Verbindungspunkt der Dioden ist durch eine Ringstruktur 32 realisiert, was Vorteile bezüglich der Integration auf einem einzelnen Chip mit sich bringt. Die Verbindungsleitung in dem Ring 32 ist so kurz wie möglich, um den Einfluss parasitärer Induktanzen der Verbindungsleitungen zu minimieren. An der Ringstruktur 32 setzen vier offene Abstimmleitungen 34 an, wobei jede der Abstimmleitungen 34 eine Länge hat, die einem Viertel der Wellenlänge der zweiten Harmonischen der Lokaloszillatorfrequenz entspricht. Auf diese Weise werden die zweiten Harmonischen kurzgeschlossen, wodurch die Konversions-verluste des Mischers verringert werden.

Es ist ein Zwischenfrequenz-Choke 36 vorgesehen, welcher eine Leitung mit einer Länge von etwa λ/4 aufweist. Diese ist an dem Zwischenfrequenzport IF über eine Reihenschaltung eines Kondensators C und eines Ohmschen Widerstandes R geerdet. Dieser Abschluss ist für die Unterdrückung störender Resonanzen in der Schaltung nützlich. Vorzugsweise hat der Kondensator eine Kapazität von einigen Pikofarad, und der Ohmsche Widerstand hat einen Wert von einigen Ohm. Der Zwischenfrequenzport IF ist so gestaltet, dass er ein Bias für die Dioden zur Verfügung stellt, um so eine Isolierung der Radiofrequenz gegen die Lokaloszillatorfrequenz und eine Lokaloszillatorunterdrückung zur Verfügung zu stellen.

## Patentansprüche

1. Mischer mit zwei Anordnungen zum Transformieren einer unausgeglichenen Übertragungsleitungsstruktur in eine ausgeglichene Übertragungsleitungsstruktur, wobei bei jeder Anordnung
- eine erste Struktur (10) vorgesehen ist,
- eine zweite Struktur (12) vorgesehen ist,
- die erste Struktur (10) drei gekoppelte parallele Leitungen (14, 16, 18) aufweist, wobei jeweils ein erstes Ende einer ersten Leitung (14) und einer dritten Leitung (18) an einem unausgeglichenen Eingangsport (26) geerdet sind und wobei die jeweils anderen Enden der ersten Leitung (14) und der dritten Leitung (18) zu zwei ausgeglichenen Ausgängen (28, 30) führen,
- die zweite Struktur (12) drei gekoppelte parallele Leitungen (20, 22, 24) aufweist, wobei jeweils ein erstes Ende einer ersten Leitung (20) und einer dritten Leitung (24) geerdet sind und wobei die jeweils anderen Enden der ersten Leitung (20) und der dritten Leitung (24) zu zwei ausgeglichenen Ausgängen (28, 30) führen, und
- eine zweite Leitung (16, 22) der ersten Struktur (10) und der zweiten Struktur (12) die Strukturen (10, 12) miteinander verbindet,
- die ausgeglichenen Ausgänge (28, 30) der jeweiligen Anordnungen paarweise miteinander verbunden sind, wobei an den Verbindungspunkten Mischerdioden (Q1, Q2, Q3, Q4) angeordnet sind, und
- eine Ringstruktur (32) zum Verbinden der Mischerdioden (Q1, Q2, Q3, Q4) vorgesehen ist, **dadurch gekennzeichnet,**
- **dass** an der Ringstruktur (32) vier offene Abstimmleitungen (34) angeschlossen sind.

2. Mischer nach Anspruch 1, **dadurch gekennzeichnet, dass** der Mischer zur Isolierung eines Lokaloszillators (LO) von einer Radiofrequenzquelle (RF) symmetrisch ist.

3. Mischer nach einem der Ansprüche 1 oder 2, **dadurch gekennzeichnet, dass** die offenen Abstimmleitungen (34) eine Länge haben, welche einem Viertel der Wellenlänge der zweiten Harmonischen des Lokaloszillators entspricht.

4. Mischer nach einem der Ansprüche 1 bis 3, **dadurch gekennzeichnet, dass** ein Zwischenfrequenz-Choke (36) mit etwa einer λ/4-Länge vorgesehen ist, welcher über eine Reihenschaltung eines Kondensators (C) und eines Ohmschen Widerstandes (R) geerdet ist.

5. Mischer nach einem der vorhergehenden Ansprüche, **dadurch gekennzeichnet, dass** die Anordnungen als planare Strukturen ausgebildet sind.

6. Mischer nach einem der vorhergehenden Ansprüche, **dadurch gekeanzeichnet,** dass Kurzschlüsse über plattierte Durchgangslöcher realisiert sind.

7. Mischer nach einem der vorangehenden Ansprüche, **dadurch gekennzeichnet, dass** die Anordnungen in Microstrip-Leitungstechnik ausgebildet sind.

8. Mischer nach einem der vorangehenden Ansprüche **dadurch gekennzeichnet, dass** die Anordnungen als monolithische integrierte Milaowellenschaltung ausgebildet sind.

9. Mischer nach einem der vorangehenden Ansprüche, **dadurch gekennzeichnet, dass** die Anordnungen als gedruckte Schaltungen in einer Einzelschicht ausgebildet sind.

10. Mischer nach einem der vorangehenden Anspruche, **dadurch gekennzeichnet, dass** die ausgeglichenen Ausgänge (28, 30) symmetrisch bezüglich Erde sind.

11. Mischer nach einem der vorangehenden Ansprüche, **dadurch gekennzeichnet, dass** die Grundfläche isoliert ist.

12. Mischer nach einem der vorangehenden Ansprüche, **dadurch gekennzeichnet, dass** die Anordnungen eine "Wiggly"-Struktur aufweisen.

13. Mischer nach einem der vorangehenden Ansprüche, **dadurch gekennzeichnet, dass** die gekoppelten Leitungsstrukturen eine λ/4-Leitung sind.

## Claims

1. Mixer with two arrangements for transforming an unbalanced transmission line structure into a balanced transmission line structure, wherein in each arrangement
- a first structure (10) is provided,
- a second structure (12) is provided,
- the first structure (10) has three coupled parallel lines (14, 16, 18), wherein in each case a first end of a first line (14) and of a third line (18) are earthed to an unbalanced input port (26) and wherein the other ends of said first line (14) and of said third line (18) lead to two balanced outputs (28, 30) respectively,
- the second structure (12) has three coupled parallel lines (20, 22, 24), wherein in each case a first end of a first line (20) and of a third line (24) are earthed and wherein the other ends of the first line (20) and of the third line (24) lead to two balanced outputs (28, 30) respectively, and
- a second line (16, 22) of the first structure (10) and of the second structure (12) connects the structures (10, 12) to one another,
- the balanced outputs (28, 30) of the respective arrays are connected to one another in pairs, with mixer diodes (Q1, Q2, Q3, Q4) arranged at the connection points, and
- a ring structure (32) is provided for connecting the mixer diodes (Q1, Q2, Q3, Q4),
**characterized in that**
- four open tuning lines (34) are connected to the ring structure (32).

2. Mixer according to Claim 1, **characterized in that** the mixer for isolation of a local oscillator (LO) from a radio frequency source (RF) is symmetrical.

3. Mixer according to one of the Claims 1 or 2, **characterized in that** the open tuning lines (34) have a length corresponding to one quarter of the wavelength of the second harmonic of the local oscillator.

4. Mixer according to one of the Claims 1 to 3, **characterized in that** an intermediate frequency choke (36) is provided with approximately a λ/4 length which is earthed via a series connection of a capacitor (C) and an ohmic resistor (R).

5. Mixer according to one of the previous claims, **characterized in that** the arrangements are designed as planar structures.

6. Mixer according to one of the previous claims, **characterized in that** short-circuits are achieved via plated through-holes.

7. Mixer according to one of the previous claims, **characterized in that** the arrangements are designed with microstrip line technology.

8. Mixer according to one of the previous claims, **characterized in that** the arrangements are designed as a monolithic integrated microwave circuit.

9. Mixer according to one of the previous claims, **characterized in that** the arrangements are designed as printed circuits in an individual layer.

10. Mixer according to one of the previous claims, **characterized in that** the balanced outputs (28, 30) are symmetrical relative to earth.

11. Mixer according to one of the previous claims, **characterized in that** the basic surface is insulated.

12. Mixer according to one of the previous claims, **characterized in that** the arrangeemnts have a "wiggly" structure.

13. Mixer according to one of the previous claims, **characterized in that** the coupled line structures are a λ/4 line.

## Revendications

1. Mélangeur avec deux configurations pour transformer une structure de ligne de transmission non équilibrée en une structure de ligne de transmission équilibrée, étant donné que pour chaque configuration
une première structure (10) est prévue,
une deuxième structure (12) est prévue,
la première structure (10) présente trois lignes couplées en parallèle (14, 16, 18), la première terminaison d'une première ligne (14) et d'une troisième ligne (18) étant mise à la terre à un port d'entrée (26) non équilibré, et les autres terminaisons de la première ligne (14) et de la troisième ligne (18) menant à deux sorties (28, 30) équilibrées,
la deuxième structure (12) présente trois lignes couplées en parallèle (20, 22, 24), la première terminaison d'une première ligne (20) et d'une troisième ligne (24) étant mise à la terre et les autres terminaisons de la première ligne (20) et de la troisième ligne (24) menant à deux sorties (28, 30) équilibrées, et
une deuxième ligne (16, 22) de la première structure (10) et de la deuxième structure (12) relient entre elles les structures (10, 12),
les sorties équilibrées (28, 30) des différentes configurations sont reliées entre elles par paire, des diodes de mélangeur (Q1, Q2, Q3, Q4) étant placées aux points de jonction, et
une structure annulaire (32) est prévue pour relier les diodes de mélangeur (Q1, Q2, Q3, Q4)
**caractérisé en ce que**
quatre lignes de syntonisation ouvertes (34) sont raccordées à la structure annulaire (32).

2. Mélangeur selon la revendication 1, **caractérisé en ce que** le mélangeur est symétrique pour isoler un oscillateur local (OL) d'une source de fréquence radio (FR).

3. Mélangeur selon les revendications 1 ou 2, **caractérisé en ce que** les lignes de syntonisation ouvertes (34) ont une longueur correspondante à un quart de la longueur d'onde du deuxième harmonique de l'oscillateur local.

4. Mélangeur selon l'une des revendications 1 à 3, **caractérisé en ce qu'**est prévu une bobine d'arrêt de fréquence intermédiaire (36) avec une longueur de λ/4, mise à la terre par l'intermédiaire du couplage en série d'un condensateur (C) et d'une résistance ohmique (R).

5. Mélangeur selon l'une des revendications précédentes, **caractérisé en ce que** les configurations sont réalisées comme structures planaires.

6. Mélangeur selon l'une des revendications précédentes, **caractérisé en ce que** les courts-circuits sont réalisés par l'intermédiaire d'orifices de passage plaqués.

7. Mélangeur selon l'une des revendications précédentes, **caractérisé en ce que** les configurations sont réalisées suivant la technique de circuit microstrip.

8. Mélangeur selon l'une des revendications précédentes, **caractérisé en ce que** les configurations sont réalisées comme circuit intégré micro-ondes monolithique.

9. Mélangeur selon l'une des revendications précédentes, **caractérisé en ce que** les configurations sont réalisées comme circuits imprimés dans une couche unique.

10. Mélangeur selon l'une des revendications précédentes, **caractérisé en ce que** les sorties équilibrées (28, 30) sont symétriques par rapport à la terre.

11. Mélangeur selon l'une des revendications précédentes, **caractérisé en ce que** la surface de base est isolée.

12. Mélangeur selon l'une des revendications précédentes, **caractérisé en ce que** les configurations présentent une structure d'un méandre.

13. Mélangeur selon l'une des revendications précédentes, **caractérisé en ce que** les structures de lignes couplées sont une ligne λ/4.
